# EUROPEAN PATENT APPLICATION

(11) **EP 2 051 289 A1**
(43) Date of publication of application: **22.04.2009**
(21) Application number: 07767555.1
(22) Date of filing: 26.06.2007
(51) Int. Cl.: H01L 21/304, B08B 1/00

(54) **CLEANING MEMBER, DELIVERY MEMBER WITH CLEANING FUNCTION, AND METHOD OF CLEANING SUBSTRATE PROCESSING APPARATUS**

(30) Priority: 11.08.2006 JP 2006219434
(71) Applicant: Nitto Denko Corporation, Ibaraki-shi, Osaka 567-8680 (JP)
(72) Inventor: TERADA, Yoshio, Ibaraki-shi, Osaka 567-8680 (JP); SUGO, Yuki, Ibaraki-shi, Osaka 567-8680 (JP); YOSHIDA, Yoshinori, Ibaraki-shi, Osaka 567-8680 (JP); MAENO, Youhei, Ibaraki-shi, Osaka 567-8680 (JP)
(74) Representative: Ilgart, Jean-Christophe
(86) International application number: PCT/JP2007/062749
(87) International publication number: WO 2008/018246

(57) **Abstract**

Provided is a cleaning member capable of removing minute foreign matter, in particular foreign matter of a submicron level simply, exactly, and sufficiently without contaminating a cleaning site. Further provided is a carrying member provided with a cleaning function having the cleaning member and a method of cleaning a substrate processing equipment with the use of the cleaning member or the carrying member provided with a cleaning function. The cleaning member of the present invention includes a layer member having a plurality of protrusions of a columnar structure on a surface, in which each of the protrusions of a columnar structure has a carbon-based nanostructure.

## Description

### TECHNICAL FIELD

The present invention relates to a cleaning member for removing minute foreign matter, a carrying member provided with a cleaning function, and a method of cleaning a substrate processing equipment with use of the cleaning member or the carrying member provided with a cleaning function. More specifically, the present invention relates to a cleaning member for removing minute foreign matter from a substrate and an apparatus that has an aversion to the foreignmatter, such as a semiconductor, a flat panel display, a printed board, and a substrate processing equipment, a carrying member provided with a cleaning function having the cleaning member, and a method of cleaning a substrate processing equipment with the use of the cleaning member or the carrying member provided with a cleaning function.

### BACKGROUND ART

In various kinds of substrate processing equipmentes and the like that have an aversion to foreign matter, such as a production apparatus and inspection apparatus of a semiconductor, a flat panel display, a printed board, and the like, each transfer system and a substrate are transferred while they are brought into contact with each other. In this case, when the foreign matter adheres to the substrate and the transfer system, the subsequent substrates are contaminated one after another, and hence it is necessary to stop the apparatus periodically so as to clean the apparatus. As a result, there arise problems in that the operation rate of the substrate processing equipment decreases, and that a great amount of labor is required for cleaning the substrate processing equipment.

In order to solve such problems described above, a method of removing foreign matter adhering to the back surface of a substrate by transferring a plate-shaped member has been proposed (see Patent Document 1). According to the method, it is not necessary to stop a substrate processing equipment so as to clean the substrate processing equipment, and hence the problem of decrease in the operation rate of the substrate processing equipment is solved. However, according to the method, minute foreign matters cannot be removed sufficiently.

On the other hand, a method of cleaning and removing foreign matter adhering to the inside of the substrate processing equipment by transferring a substrate with an adherent material adhering thereto in the substrate processing equipment as a cleaning member has been proposed (see Patent Document 2) . The method has not only an advantage of the method described in Patent Document 1, but also excellent foreign matter removing performance. Therefore, the method solves the problem in that the operation rate of the substrate processing equipment decreases and the problem in that a great amount of labor is required for cleaning the substrate processing equipment.

As described above, the method of cleaning and removing foreign matter with a cleaning member having a pressure-sensitive material is excellent as a method of removing foreign matter effectively. However, this method may cause a problem that the pressure-sensitive material adheres to a cleaning site too strongly to be peeled therefrom, and a problem that a pressure-sensitive adhesive remains at the cleaning site to thereby reversely contaminate the site. There is also a problem that, in the case where the tackiness is decreased for the purpose of preventing an adhesive from remaining, the essential dust-removing property is degraded.

Further, if a method of wiping with a cotton waste impregnated with alcohol (alcohol wiping) is used as a method of removing foreignmatter, there is aproblemthat the foreign matter may remain and the foreign matter may be removed unevenly. Thus, the dust-removing property is degraded.

Recently, the size of minute foreign matter which causes a problem in a substrate and an apparatus that have an aversion to the foreign matter has reached a submicron (1 µm or less) level. According to the above method, it is difficult to remove the foreign matter of a submicron size exactly.

In order to remove the foreign matter having a particle size of about tens of microns, a cleaning wafer on the surface of which a dot pattern of about tens of microns is formed by a photoresist or cutting/polishing has been proposed (see Patent Document 3). In the cleaning wafer, the foreign matter is held in a space portion of a dot pattern to be removed. Therefore, although foreign matter having a particle size of about tens of microns can be removed, it is difficult to remove minute foreign matter of a submicron size sufficiently.
Patent Document 1: JP 11-87458 A
Patent Document 2: JP 10-154686 A
Patent Document 3: JP 2004-63669 A

### DISCLOSURE OF THE INVENTION: PROBLEMS TO BE SOLVED BY THE INVENTION

An object of the present invention is to provide a cleaning member capable of removing minute foreign matter, or preferably foreign matter of a submicron level simply, exactly, and sufficiently, without contaminating a cleaning site. Another object of the present invention is to provide a carrying member provided with a cleaning function having the cleaning member, and a method of cleaning a substrate processing equipment with the use of the cleaning member or the carrying member provided with a cleaning function.

### MEANS FOR SOLVING THE PROBLEMS

As a result of the earnest study for the purpose of solving the above-mentioned problems, the inventors of the present invention have found that the above problems can be solved by providing a plurality of protrusions of a columnar structure formed of a carbon-based nanostructure on the surface of a layer member provided on the cleaning member, thereby achieving the present invention.

A cleaning member of the present invention includes a layer member with a plurality of protrusions of a columnar structure on a surface, in which each of the protrusions of a columnar structure has a carbon-based nanostructure.

In a preferred embodiment, the carbon-based nanostructure is a carbon nanotube.

In a preferred embodiment, a length of a portion with a maximum diameter of the carbon-based nanostructure is 100 nm or less.

Inapreferredembodiment, alengthofaprotruding portion of the carbon-based nanostructure is 50 µm or less.

In a preferred embodiment, a density of the carbon-based nanostructure on a surface of the layer member is 1.0 × 10⁹ pieces/cm² or more.

In a preferred embodiment, the cleaning member is used for removing foreign matter on a substrate.

In a preferred embodiment, the cleaning member is used for removing foreign matter in a substrate processing equipment.

According to another aspect of the present invention, a carrying member provided with a cleaning function is provided. The carrying member provided with a cleaning function includes a carrying member and the cleaning member provided on at least one surface of the carryingmember.

According to another aspect of the present invention, a method of cleaning a substrate processing equipment is provided. One method of cleaning a substrate processing equipment of the present invention includes delivering the cleaning member into the substrate processing equipment. Another aspect of the method of cleaning a substrate processing equipment of the present invention includes delivering the carrying member provided with a cleaning function into the substrate processing equipment.

### EFFECTS OF THE INVENTION

According to the present invention, the cleaning member capable of removing minute foreign matter, in particular foreign matter of a submicron level simply, exactly, and sufficiently without contaminating a cleaning site can be provided. Further, the carrying member provided with a cleaning function having the cleaning member, and the method of cleaning a substrate processing equipment with the use of the cleaning member or the carrying member provided with a cleaning function can be provided.

The above-mentioned effects can be achieved by providing a plurality of protrusions of a columnar structure formed of a carbon-based nanostructure on the surface of a layer member provided on the cleaning member. Such effects can be expressed effectively, particularly due to the three-dimensional entanglement between the minute foreign matter of a submicron level and the carbon-based nanostructure, and the Van der Waals attraction between the minute foreign matter of a submicron level and the carbon-based nanostructure.

### BRIEF DESCRIPTION OF THE DRAWINGS

FIGS. **1** are schematic cross-sectional views of a cleaning member obtained by a preferred embodiment of the present invention.
FIG. **2** is a schematic cross-sectional view of a carrying member provided with a cleaning function obtained by a preferred embodiment of the present invention.

### DESCRIPTION OF SYMBOLS

**10** support
**20** cleaning layer
**30** protrusion of a columnar structure formed of a carbon-based nanostructure
**50** carrying member
**100** cleaning member
**200** carrying member provided with a cleaning function

### BEST MODE FOR CARRYING OUT THE INVENTION

### A. Cleaning member

The cleaning member of the present invention has a layer member. As the layer member in the present invention, any suitable member can be adopted as long as the member has a layer structure. Preferably, the cleaning member includes a support, a cleaning layer, and a carrying member, as described below.

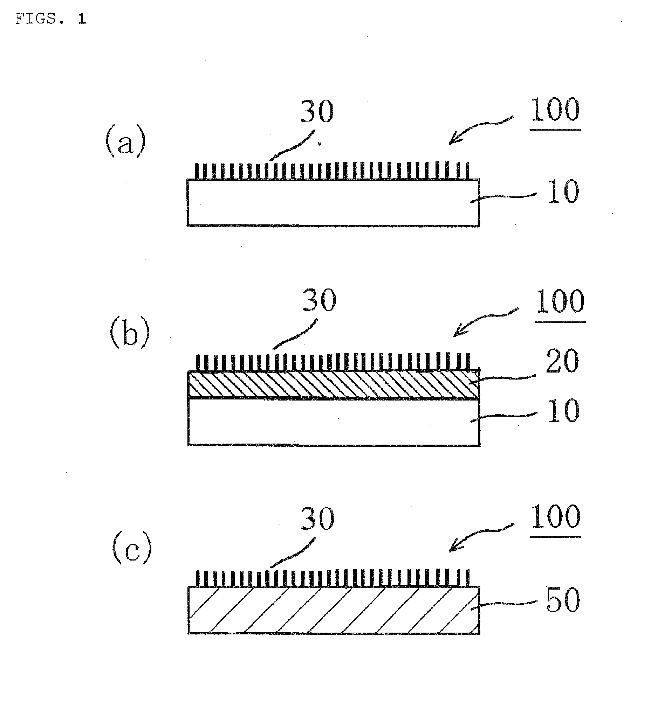

FIGS. **1(a), (b),** and **(c)** are schematic cross-sectional views of the cleaning member in a preferred embodiment of the present invention.

In the embodiment of FIG. **1(a)****,** a cleaning member **100** includes a support **10** that is a layer member, and protrusions **30** of a columnar structure formed of a carbon-based nanostructure provided on the surface of the support **10**. The protrusions **30** may be provided on at least one surface of the support **10**. More specifically, the protrusions **30** may be provided only on one surface or on both surfaces.

In the embodiment of FIG. **1(b)****,** the cleaning member **100** includes the support **10** and a cleaning layer **20** that is a layer member. The support **10** may be omitted in accordance with the purpose. The cleaning layer **20** has a plurality of protrusions **30** of a columnar structure formed of a carbon-based nanostructure on the surface. In the embodiment of FIG. **1(b)****,** in the case where the cleaning layer **20** is provided on the support **10**, the surface on which the cleaning layer **20** is provided may be provided on at least one surface of the support **10**. More specifically, the surface on which the cleaning layer **20** is provided may be provided only on one surface or on both surfaces. Further, the surface on which the cleaning layer **20** is provided may be provided over the entire surface or only on a part such as an end surface (edge portion).

In the embodiment of FIG. **1(c)****,** the cleaning member **100** includes a carrying member 50 that is a layer member, and protrusions **30** of a columnar structure formed of a carbon-based nanostructure provided on the surface. The protrusions **30** may be provided on at least one surface of the carrying member **50**. More specifically, the protrusions **30** may be provided on one surface or on both surfaces. In the embodiment of FIG. **1(c)****,** since protrusions of a columnar structure formed of a carbon-based nanostructure are provided on the surface of the carrying member, the cleaning member **100** is delivered as it is into the substrate processing equipment, thereby cleaning the substrate processing equipment.

The protrusions **30** of a carbon-based nanostructure have a columnar structure. The columnar structure according to the present invention also includes a substantially columnar structure as well as a strictly columnar structure. Examples of the columnar structure include a cylindrical structure, a polygonal columnar structure, a cone-shaped structure, and a fiber-shaped structure. Further, the cross-sectional shape of the columnar structure may be uniform or non-uniform over the entire protrusions. Further, the protrusions may protrude along a substantially straight line or along a curved line.

Examples of the carbon-based nanostructure include a carbon nanotube and a carbon nanofiber. Preferably, the carbon-based nanostructure is the carbon nanotube. As the carbon nanotube, a single-layer carbon nanotube may be adopted, or a multiwall carbon nanotube may be adopted. In terms of the mechanical strength, the multiwall carbon nanotube is preferred.

In the present invention, by adopting a carbon-based nanostructure as a plurality of protrusions of a columnar structure provided on the surface of the layer member of the cleaning member, a cleaning member capable of removing minute foreign matter, preferably foreign matter of a submicron level can be provided simply, exactly, and sufficiently without contaminating a cleaning site. Such effects can be expressed effectively, particularly due to the three-dimensional entanglement between the minute foreign matter of a submicron level and the carbon-based nanostructure, and the Van der Waals attraction between the minute foreign matter of a submicron level and the carbon-based nanostructure.

As an angle formed by the protruding direction of the protrusions of a columnar structure formed of a carbon-based nanostructure and the surface of the layer member, any suitable angle can be adopted in a range in which the object of the present invention can be achieved. For example, the protrusions may protrude from the surface of the layer member substantially perpendicularly or may protrude from the surface of the layer member diagonally.

The length of the portion with a maximum diameter of the carbon-based nanostructure is preferably 100 nm or less, more preferably 1 to 100 nm, much more preferably 1 to 80 nm, particularly preferably 5 to 60 nm, and most preferably 10 to 50 nm. When the length of the portion with a maximum diameter of the carbon-based nanostructure is in the above range, the minute foreign matter, preferably the foreign matter of a submicron level can be removed simply, exactly, and sufficiently. The "length of a portion with a maximum diameter of the carbon-based nanostructure" according to the present invention refers to the length of a portion with a longest diameter in the cross-section of the carbon-based nanostructure of a columnar structure. For example, in the case where the cross-section has a substantially circular shape, the "length of a portion with a maximum diameter of the carbon-based nanostructure" according to the present invention refers to the length of a portion with a diameter of the substantially circular portion.

The length of a protrusion portion of the carbon-based nanostructure is preferably 50 µm or less, more preferably 1 to 50 µm, much more preferably 1 to 40 µm, particularly preferably 5 to 40 µm, and most preferably 5 to 30 µm. When the length of the protrusion of the carbon-based nanostructure is in the above range, the minute foreign matter, preferably the foreign matter of a submicron level can be removed simply, exactly, and sufficiently.

The length of the portion with a maximum diameter of the carbon-based nanostructure and the length of the protrusion portion of the carbon-based nanostructure may be measured by any suitable measurement method. In terms of the ease of measurement and the like, preferably measurement using a scanning electron microscope (SEM) can be used. According to the scanning electron microscope (SEM), for example, by attaching a layer member having a plurality of protrusions of a columnar structure formed of a carbon-based nanostructure to the surface of a SEM observation sample base and observing the layer member from a side surface direction, the length of the protruding portion of the protrusions of a columnar structure formed of a carbon-based nanostructure can be obtained.

In the present invention, the density of a carbon-based nanostructure on the surface of the layer member is preferably 1.0 × 10⁹ pieces/cm² or more, more preferably 5.0 × 10⁹ pieces/cm² or more, and much more preferably 1.0 × 10¹⁰ pieces/cm² or more. The upper limit of the density of the carbon-based nanostructure on the surface of the layer member is preferably 1.0 × 10¹⁴ pieces/cm² or less, more preferably 1.0 × 10¹³ pieces/cm² or less, and much more preferably 1.0 × 10¹² pieces/cm² or less. When the density of the carbon-based nanostructure on the surface of the layer member is in the above range, the minute foreign matter, preferably the foreign matter of a submicron level can be removed simply, exactly, and sufficiently.

In the present invention, as a method of forming protrusions of a columnar structure formed of a carbon-based nanostructure on the surface of the layer member, any suitable method can be adopted in a range in which the object of the present invention can be achieved. For example, the protrusions can be formed by a laser evaporation method, an arc discharge method, a chemical vapor deposition (CVD) method, or the like.

According to the laser evaporation method, carbon mixed with a catalyst such as nickel/cobalt is irradiated with strong pulse light of a YAG laser, whereby a single-wall carbon nanotube (SWCNT) with a relatively high purity can be formed. Further, the diameter of the tube can be controlled by changing conditions.

According to the arc discharge method, arc discharge of about 20 V/50 A is performed between carbon bars in an argon or hydrogen atmosphere at a pressure relatively lower than atmosphere pressure, whereby a multiwall carbon nanotube (MWCNT) can be formed in an anode deposition. When arc discharge is performed using a catalyst such as nickel/cobalt mixed in carbon bars, a single-wall carbon nanotube (SWCNT) can be generated in a substance adhering to the inside of a container as soot. According to the arc discharge method, a carbon nanotube of good quality can be formed with less defects.

According to the chemical vapor deposition (CVD) method, hydrocarbon such as methane and acetylene, carbon monoxide, alcohol, or the like as a material is brought into contact with catalyst metal fine particles at 500 to 1, 000°C, whereby a carbon nanotube can be formed. If the chemical vapor deposition (CVD) method is used, a multiwall carbon nanotube (MWCNT) and a single-wall carbon nanotube (SWCNT) can be formed by changing conditions such as the kind and arrangement of a catalyst metal and the kind of a carbon compound. Further, according to the chemical vapor deposition (CVD) method, catalyst metal fine particles are placed on a particular substrate, whereby a carbon nanotube aligned substantially perpendicularly to the surface of the substrate can be obtained, and hence, the chemical vapor deposition (CVD) method is used preferably in the present invention.

In the present invention, it is preferred that the carbon-based nanostructure be aligned in a predetermined direction from the surface of the layer member. If the carbon-based nanostructure is aligned in a predetermined direction from the surface of the layer member, minute foreign matter, preferably foreign matter of a submicro level can be removed simply, exactly, and sufficiently.

As a method of aligning the carbon-based nanostructure in a predetermined direction from the surface of the layer member, any suitable method can be adopted. Examples of the method of selectively forming a carbon nanotube aligned in a substantially perpendicular direction with respect to the surface of the layer member include: a method of growing a carbon nanotube, using electrical field application type plasma CVD, in any pattern made of Ni, Fe, and Co formed by a method such as sputtering, plating, or sintering after the application of an organic metal compound; a method of aligning a catalyst by allowing a catalyst-containing solution to adhere to the surface of the layer member by an ink-jet method; and a method of heat-treating a multi-layer catalyst metal pattern in which at least two kinds of different catalyst metal layers are laminated before subjecting the pattern to a CVD method.

A carbon nanotube can also be formed from silicon carbide (SiC) by a surface degradation method. According to this method, SiC is heated in vacuum to remove Si, whereby a carbon nanotube can be formed. The carbon nanotube formed by this method tends to be aligned substantially perpendicularly to the surface of the substrate.

The tensile modulus of elasticity of the cleaning layer is preferably 0.5 MPa or more, more preferably 1 to 10,000 MPa, and much more preferably 10 to 10,000 MPa in ause temperature region of the cleaningmember. If the tensile modulus of elasticity is in such a range, a cleaning member excellent in the balance between the foreign matter removability and the delivery property is obtained. The tensile modulus of elasticity is measured in accordance with JIS K7127. By setting the tensile modulus of elasticity of the cleaning layer in the above range, minute foreign matter, preferably foreign matter of a submicron level can be removed simply, exactly, and sufficiently.

The 180° peeling tackiness of the cleaning layer with respect to, for example, the mirror surface of a silicon wafer is preferably 0.2 N/10 mm width or less and more preferably 0.01 to 0.10 N/10 mm width. In such a range, the cleaning layer has satisfactory foreign matter removability and a delivery property. The 180° peeling tackiness is measured in accordance with JIS Z0237.

Regarding the thickness of the cleaning layer, any suitable conditions can be adopted in a range in which the object of the present invention can be achieved. The thickness of the cleaning layer is preferably 1 to 200 µm, more preferably 5 to 100 µm, much more preferably 5 to 50 µm, and particularly preferably 5 to 20 µm. In such a range, minute foreign matter, preferably foreign matter of a submicron level can be removed simply, exactly, and sufficiently.

The cleaning layer substantially does not preferably have tackiness. Herein, having substantially no tackiness means that there is not pressure-sensitive tackiness typifying the function of tackiness, when the nature of the tackiness is assumed to be the friction that is a resistance to slippery. The pressure-sensitive tackiness is expressed in the range of up to 1 MPa of the modulus of elasticity of a pressure-sensitive material in accordance with Dahlquist, for example.

Any suitable material maybe employed as a material forming the above-mentioned cleaning layer as long as the object of the present invention can be accomplished. Specific examples of the material forming the cleaning layer include: a polymer resin such as a polyimid-based resin, a polyester-based resin, a fluorine-based resin, an acrylic-based resin, an epoxy-based resin, a polyolefin-based resin,polyvinylchloride,EVA,PEEK,PMMA, or POM; and an inorganic material such as a quartz substrate, a glass substrate, or silicon. In particular, the polyimid-based resin, polyester-based resin, and silicon are preferably used because of their good heat resistance.

The material forming the cleaning layer further can contain any suitable additive in a range in which the object of the present invention can be achieved. Specific examples of the additive include a surfactant, aplasticizer, an antioxidant, a conductivity providing material, a UV-absorber, and a light stabilizer. By adjusting the kind and/or the amount of an additive to be used, a cleaning layer having desired properties in accordance with the purpose can be obtained.

The cleaning layer may be formed by any suitable method in a range in which the object of the present invention can be achieved. Examples of the method of forming a cleaning layer include a method of forming a cleaning layer as a single layer film, a method of applying a resin to a support, and a method of attaching a resin layer separately formed to a support. More specific examples include a method of using a single layer film, a method of directly applying a cleaning layer to a support (e.g., the carrying member) such as a silicon wafer by a spin-coating method or spraying method, and a method of forming a cleaning layer by applying it to a PET film or a polyimide film by a comma coating method, a fountain method, a gravure method, or the like.

As the support, any suitable support canbe adopted. Any appropriate thickness of the support can be adopted as long as the object of the present invention is achievable. The thickness is preferably 500 µm or less, more preferably 3 to 300 µm, and most preferably 5 to 250 µm.

The surface of the support may be subjected to conventional surface treatment, e.g., chemical or physical treatment such as chromic acid treatment, ozone exposure, flame exposure, high-pressure electrical-shock exposure, and ionized radiation treatment, or application treatment with an undercoating agent (e.g., the above adherent material) in order to enhance the adhesion with respect to an adjacent layer, a retention property, and the like. The support may be a single layer or a multilayered body.

As the material for the support, any suitable material is adopted according to the purpose as long as the object of the present invention is achievable. Examples of the material for the support include an engineering plastic film and a super engineering plastic film. Specific examples of the engineering plastic and the super engineering plastic include polyimide, polyethylene, polyethylene terephthalate, acetyl cellulose, polycarbonate, polypropylene, and polyamide. As physical properties such as a molecular weight, any appropriate physical properties can be adopted as long as the object of the present invention is achievable. As a method of forming the support, any appropriate method can be adopted as long as the object of the present invention is achievable.

The cleaning layer may typically have a protective film attached thereto preliminarily, and the film can be peeled at an appropriate stage such as during application. The protective film can be typically used for the purpose of protecting the cleaning layer when the cleaning layer is formed or the cleaning layer is attached (crimped) to the support.

Any appropriate film may be employed as the appropriate protective film as long as the object of the present invention can be accomplished. Examples of the protective film include: plastic films made of polyolefins such as polyethylene, polypropylene, polybutene, polybutadiene, and polymethylpentene, polyvinyl chloride, a vinyl chloride copolymer, polyethylene terephthalate, polybutyleneterephthalate,polyurethane,an ethylene vinyl acetate copolymer, an ionomer resin, an ethylene (meth)acrylic acid copolymer, an ethylene (meth)acrylate copolymer,polystyrene,and polycarbonate;a polyimidefilm; and a fluorine resin film.

It is preferred that the protective film be subjected to a releasing treatment with a releasing treatment agent in accordance with the purpose. Examples of the releasing treatment agent include a silicone-based compound, a long-chain alkyl-based compound, a fluorine-based compound, an aliphatic acid amide-based compound, and a silica-based compound. The silicone-based compound is particularly preferred.

Polyolefin resin-based films such as polyethylene, polypropylene, polybutene, polybutadiene, and polymethylpentene films exhibit a releasing property with no releasing treatment agent being used. Thus, those films may also be used alone as a protective film.

The protective film has a thickness of preferably 1 to 100 µm, or more preferably 10 to 100 µm. As a method of forming the protective film, any suitable method may be adopted as long as the object of the present invention can be accomplished. For instance, an injection molding method, an extrusion molding method, or a blow molding method can be used to form the film.

As the application of the cleaning member of the present invention, any suitable application can be adopted in the range of the obj ect of the present invention. Preferably, the cleaning member is used for removing foreign matter on a substrate and removing foreign matter in a substrate processing equipment. More specifically, the cleaning member is used preferably for cleaning a substrate processing equipment that has an aversion to minute foreign matter, such as a production apparatus and an inspection apparatus of a semiconductor, a flat panel display, and a printed board. As a carrying member used for cleaning by being delivered in a substrate processing equipment, any suitable carrying member can be adopted in the range of the obj ect of the present invention. Specifically, examples include a substrate for a flat panel display such as a semiconductor wafer, an LCD, or a PDP, and a substrate for a compact disk, an MR head, or the like.

In the present invention, there is no particular limit to a substrate processing equipment in which dust-removing is performed, and examples of the substrate processing equipment include an exposure apparatus, a resist applying apparatus, a developing apparatus, an ashing apparatus, a dry etching apparatus, an ion implantation apparatus, a PVD apparatus, a CVD apparatus, an outer appearance inspection apparatus, and a wafer prober.

### B. Carrying member provided with a cleaning function

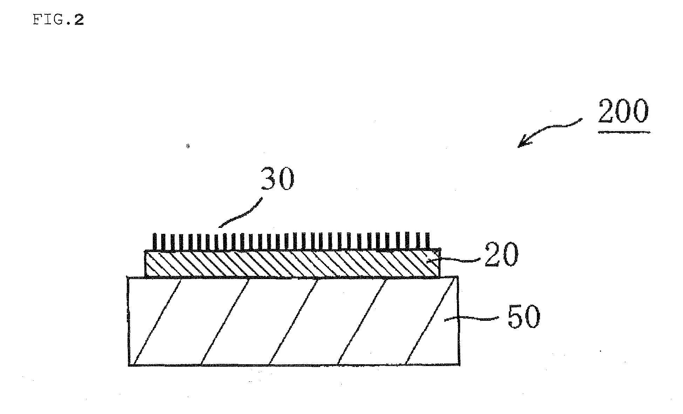

FIG. **2** is a schematic cross-sectional view of a carrying member provided with a cleaning function in the present invention. As shown in FIG. **2**, the carrying member provided with a cleaning function **200** includes a carrying member **50** and a cleaning layer **20** at least on one surface (one surface in the illustrated example) of the carrying member **50**. Specifically, in this embodiment, the cleaning layer **20** is formed directly on the carrying member **50**. Such a carrying member provided with a cleaning function is delivered in an apparatus and is brought into contact with and moved to a site to be cleaned, whereby foreign matter can be cleaned and removed simply and exactly without causing any delivery trouble due to the foreign matter adhering to the inside of the apparatus.

As the carrying member **50** of the present invention as shown in FIG. **1(c)** and FIG. **2**, any suitable substrate is used depending upon the kind of a substrate processing equipment from which foreign matter is to be removed. Specific examples of the substrate include a substrate for a flat panel display such as a semiconductor wafer (e.g., a silicon wafer), an LCD, or a PDP, and a substrate for a compact disk, an MR head, or the like.

Regarding the cleaning layer **20** in the carrying member provided with a cleaning function, the description of the cleaning layer in the A item can be adopted.

The carrying member provided with a cleaning function may be produced with a cleaning sheet attached to a carrying member or with a cleaning layer directly provided on at least one surface of the carrying member. More specifically, the cleaning layer may be formed by a method of applying a curable resin composition or a polymer resin having heat resistance described in the A item as a material for the cleaning layer, curing the resin composition or the polymer resin with an active energy source, or drying the resin composition or the polymer resin, followed by heat-treatment at a high temperature. After forming or in the course of forming the cleaning layer, preferably the protective film described in the A item is attached on the cleaning layer.

### C. Cleaning method

The cleaning method in the present invention includes delivering the cleaning member of the present invention (preferably, the embodiment shown in FIG. **1(c)**) or the carrying member provided with a cleaning function of the present invention into a substrate processing equipment. The cleaning member (preferably, the embodiment shown in FIG. **1(c)**) of the present invention or the carrying member provided with a cleaning function of the present invention is delivered into a desired substrate processing equipment, and brought into contact with a site to be cleaned, whereby foreign matter adhering to the site to be cleaned can be cleaned and removed simply and exactly.

There is no particular limit to the substrate processing equipment to be cleaned by the cleaning method. Specific examples of the substrate processing equipment include not only the apparatuses described herein but also various kinds of production apparatuses and inspection apparatuses such as an exposure irradiation apparatus for forming a circuit, a resist application apparatus, a sputtering apparatus, an ion implantation apparatus, a dry etching apparatus, and a wafer prober, and substrate processing equipmentes, which are used at high temperature, such as an ozone asher, aresistcoater, an oxidation diffusion furnace, an ordinary pressure CVD apparatus, a reduced-pressure CVD apparatus, and a plasma CVD apparatus.

### EXAMPLES:

Hereinafter, the present invention is described more specifically by way of examples, but is not limited to those examples. Further, a "part" in the examples is based on the weight.

### [Density of carbon-based nanostructure on surface of layer member]

The density of a carbon-based nanostructure on the surface of a layer member was measured by counting the number of protrusions of a columnar structure formed of a carbon-based nanostructure on the surface of 1 cm² of the layer member.

### [Length of portion with maximum diameter and length of protrusion of carbon-based nanostructure]

The length of a portion with a maximum diameter and the length of a protrusion of the carbon-based nanostructure were measured by SEM observation of a layer member from a side surface.

### [Dust-removing property]

The dust-removing property was evaluated by the following method. More specifically, silicon powders with an average particle size of 0.5 µm were allowed to adhere onto a 4-inch silicon wafer so that the number of particles was about 10,000. Then, a layer member side of a cleaning member having a layer member with protrusions of a columnar structure formed of a carbon-based nanostructure on the surface was brought into contact with on the 4-inch silicon wafer with silicon powders adhering thereto for one minute. Then, thecleaningmemberwaspeeled, and the number of silicon powder particles of 0.5 µm was measured by a particle counter (SurfScan-6200, manufactured by KLA tencor Corporation), whereby a dust-removing ratio was calculated. The measurement was performed three times, and the average thereof was obtained.

### [Examples 1 to 4]

Cobalt/molybdenum was dissolved in ethanol as catalyst metal and applied onto a silicon wafer. The catalyst metal was subjected to oxidation treatment at 250°C, whereby metal fine particles were formed uniformly on the silicon wafer. After that, alcohol was heated to 700°C in an electric furnace and vaporized, whereby a multiwall carbon nanotube (MWCNT) aligned perpendicularly was formed on the catalyst metal. Thus, cleaning members (1) to (4) having a layer member provided with a plurality of protrusions of a columnar structure formed of a carbon-based nanostructure on the surface were produced.

Multiwall carbon nanotube structures formed on the cleaning members (1) to (4) were observed with a scanning electron microscope (SEM). Table 1 shows the length of a portion with a maximum diameter and the length of a protrusion of the obtained multiwall carbon nanotube structures, and the density of the carbon-based nanostructures on the surface of the layer member. Table 1 also shows the dust-removing property of the cleaning members (1) to (4).

### [Comparative Example 1]

A silicon wafer having no protrusion of a columnar structure formed of a carbon-based nanostructure on the surface was assumed to be a cleaning member (C1). Table 1 shows the dust-removing property of the cleaning member (C1).

**[Table 1]**

| | Example 1 | Example 2 | Example 3 | Example 4 | Comparative Example 1 |
|---|---|---|---|---|---|
| Length of portion with maximum diameter (nm) | 10 | 1 | 50 | 100 | N.A |
| Length of protrusion portion (µm) | 5 | 1 | 30 | 50 | N.A |
| Density (pieces/cm2) | 1.0 × 10¹¹ | 1.0 × 10⁹ | 1.0 × 10¹² | 1.0 × 10⁹ | N.A |
| Dust-removing property (%) | 95 | 85 | 90 | 80 | 40 |

As is understood from Table 1, excellent dust-removing property was shown in Examples 1 to 4, whereas sufficient dust-removing property was not obtained in Comparative Example 1.

### INDUSTRIAL APPLICABILITY

The cleaning member and the carrying member provided with a cleaning function of the present invention are preferably used for cleaning a substrate processing equipment such as various kinds of production apparatuses and inspection apparatuses.

## Claims

1. A cleaning member comprising a layer member (20) with a plurality of protrusions (30) of a columnar structure on a surface, wherein each of the protrusions of a columnar structure has a carbon-based nanostructure.

2. A cleaning member according to claim 1, wherein the carbon-based nanostructure is a carbon nanotube.

3. A cleaning member according to claim 1 or 2, wherein a length of a portion with a maximum diameter of the carbon-based nanostructure is 100 nm or less.

4. A cleaning member according to any one of claims 1 to 3, wherein a length of a protruding portion of the carbon-based nanostructure is 50 µm or less.

5. A cleaning member according to any one of claims 1 to 4, wherein a density of the carbon-based nanostructure on a surface of the layer member is 1.0 × 10⁹ pieces/cm² or more.

6. A cleaning member according to any one of claims 1 to 5, which is used for removing foreign matter on a substrate.

7. A cleaning member according to any one of claims 1 to 5, which is used for removing foreign matter in a substrate processing equipment.

8. A carrying member provided with a cleaning function comprising a carrying member and the cleaning member according to claim 7 provided on at least one surface of the carrying member.

9. A method of cleaning a substrate processing equipment, comprising delivering the cleaning member according to claim 7 into the substrate processing equipment.

10. A method of cleaning a substrate processing equipment, comprising delivering the carrying member provided with a cleaning function according to claim 8 into the substrate processing equipment.
